(19) Europäisches Patentamt
European Patent Office
Office européen des brevets

(11) **EP 2 858 222 A2**

(12) **EUROPEAN PATENT APPLICATION**
published in accordance with Art. 153(4) EPC

(43) Date of publication:
**08.04.2015 Bulletin 2015/15**

(51) Int Cl.:
**H02M 3/155** (2006.01)    **H02M 7/12** (2006.01)

(21) Application number: **13796268.4**

(86) International application number:
**PCT/JP2013/065286**

(22) Date of filing: **31.05.2013**

(87) International publication number:
**WO 2013/180297 (05.12.2013 Gazette 2013/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **31.05.2012   JP 2012125428**

(71) Applicants:
• **Nagasaki University,
National University Corporation
Nagasaki-shi
Nagasaki 852-8521 (JP)**

• **Panasonic Corporation
Kadoma-shi, Osaka 571-8501 (JP)**

(72) Inventors:
• **KUROKAWA Fujio
Nagasaki-shi
Nagasaki 852-8521 (JP)**
• **OHNISHI Masahito
Kadoma-shi
Osaka 571-8501 (JP)**

(74) Representative: **Wittmann, Günther et al
Wittmann Hernandez
Patentanwälte Partnerschaft mbB
Frans-Hals-Strasse 31
81479 München (DE)**

(54)    **CONTROL DEVICE FOR POWER CONVERSION CIRCUIT**

(57)    The control device 1A includes an on-time information generation circuit 11, a zero cross detecting circuit 12 and a PWM signal generation circuit 13.

The on-time information generation circuit 11 inputs at least a power converter circuit information including an output voltage value of a power converter circuit 2, and generates the on-time information about a switch 212.

The zero cross detecting circuit 12 detects a time when a inductor current becomes zero by inputtin a voltage between both terminals of the inductor 214, and generates a zero cross detection signal when the inductor current became zero.

The PWM signal generation circuit 13 inputs the on-time information and the zero cross detection signal, and generates a turn on signal and a turnoff signal.

The zero cross detecting circuit 12 has an edge detecting circuit.

The zero cross detecting circuit 12 generates a zero cross detection signal when the edge detecting circuit detected an edge appearing in a voltage between both terminals of the inductor 214.

The PWM signal generation circuit 13 generates a turn-on signal when a zero cross detection signal was input.

The PWM signal generation circuit 13 generates the turn-off signal, when a time based on the on-time information passed,

In this way, by the present invention, a change of the inductor current is acquired precisely, and a good critical mode control is carried out.

Fig. 1

EP 2 858 222 A2

# Description

## FIELD OF THE INVENTION

The present invention relates to a control device of a power converter circuit (a DC/DC converter circuit or an AC/DC converter circuit) detecting a zero cross point of an inductor current.

More particularly, the present invention relates to the control device of the power converter circuit that can perform a good critical mode control by detecting a change of the inductor current precisely.

## BACKGROUND ART

A control mode of the power converter circuit (a DC/DC CONVERTER or an AC/DC converter) includes a continuous mode, a discontinuous mode and a critical mode conventionally (refer to a patent document 1).

The critical mode is a mode of a border between the continuous mode and the discontinuous mode.

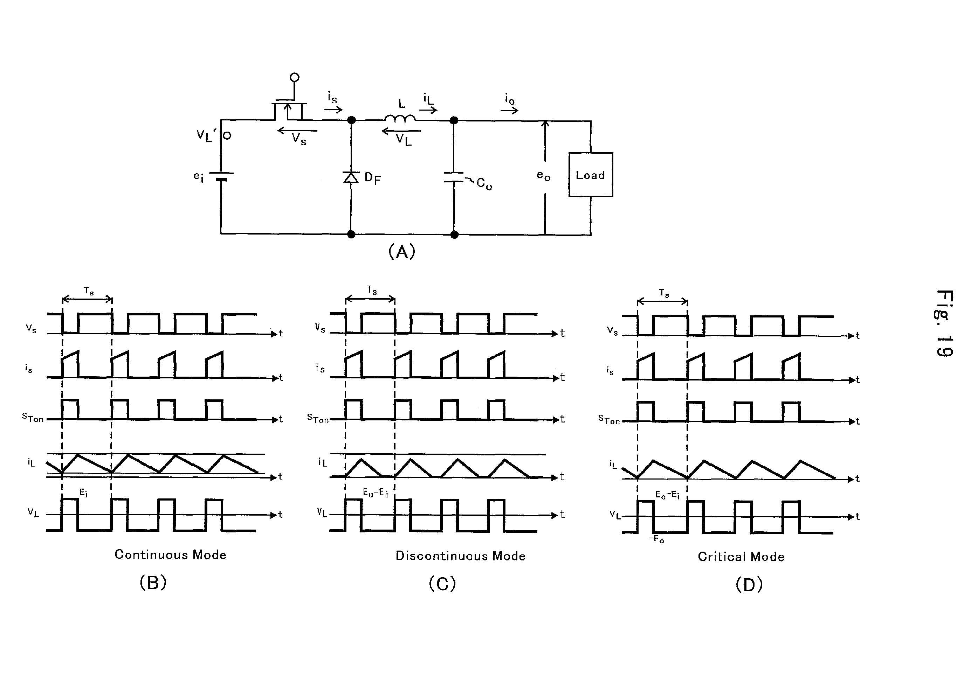

FIG. 19 (A) shows a buck type (a step-down type) DC/DC converter.

FIG. 19 (B) shows each waveform in several points of the buck type DC/DC converter working in the continuous mode.

FIG. 19 (B) shows each waveform in several points of the buck type DC/DC converter working in the discontinuous mode.

FIG. 19 (B) shows each waveform in several points of the buck type DC/DC converter working in the critical mode.

Vs, is, STON, iL and VL in FIG. 19 (B), FIG. 19 (C) and FIG. 19 (D) show a switch voltage Vs, a switch current is, a switch drive signal STON, an inductor current iL and an inductor voltage VL in FIG. 19 (A), respectively.

A power factor in the critical mode (refer to FIG. 19 (D)) is usually higher than a power factor in the continuous mode (refer to FIG. 19 (B)) and a power factor in the discontinuous mode (refer to FIG. 19 (C)).

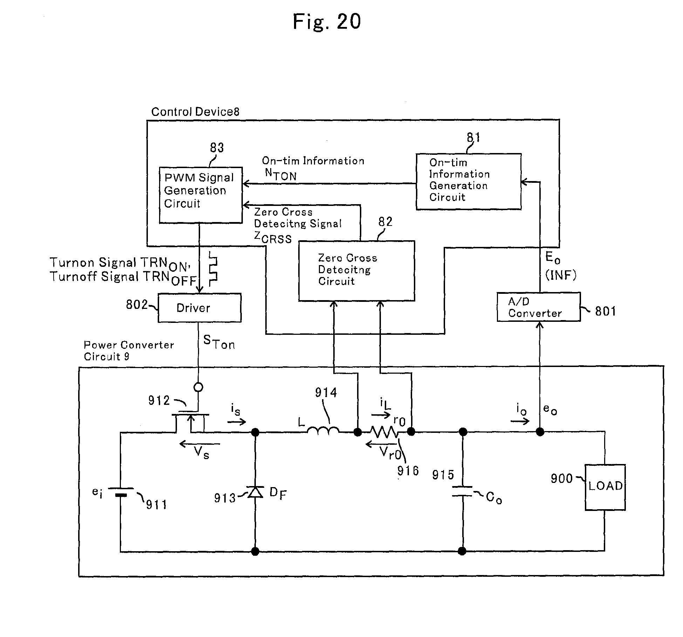

FIG. 20 shows a conventional power conversion system to work in the critical mode, wherein a control device 8 is provided to an output stage of a power converter circuit 9.

In FIG. 20, the power converter circuit 9 is a buck type DC/DC converter.

The power converter circuit 9 comprises a power supply 911, a switch 912 (a transistor), a flywheel diode 913 (DF), an inductor 91 (L) and a capacitor 915 (CO).

The DC power supply 911 is provided to an input stage of the power converter circuit 9.

A power input terminal of the switch 912 is connected to a positive terminal of the DC power supply 911.

A cathode terminal of the flywheel diode 913 (DF) is connected to a power output terminal of the switch 912, and the anode terminal is grounded.

A terminal of the inductor 914 (L) is connected to the power output terminal of the switch 912, and another terminal of the inductor 914 (L) is connected to a terminal of the capacitor 915 (CO).

Another terminal of the capacitor 915 (CO) is grounded.

A load 900 is connected to both terminals of the capacitor 915.

A resistance 916 (r0) for detecting an inductor current is connected to the inductor 914.

A secondary winding can be provided to the inductor 914.

A resistance for detecting the inductor current can be connected to the secondary winding.

In the power converter circuit 9, energy is accumulated to the inductor 914 when the switch 912 turned on.

On the other hand, the energy accumulated to the inductor 914 is sent out to the load 900 when the switch 912 turned off.

The control device 8 includes an on-time information generation circuit 81, a zero cross detecting circuit 82 and a PWM signal generation circuit 83.

The on-time information generation circuit 81 inputs a power converter circuit information INF including at least an output voltage value EO of the power converter circuit 9, and the on-time information generation circuit 81 generates the on-time information NTON of the switch 912.

An output voltage eO of the power converter circuit 9 is converted to a digital signal (the output voltage EO) by an A/D converter 801, and the output voltage EO is input to the on-time information generation circuit 81.

The on-time information generation circuit 81 is typically a PID control circuit.

The on-time information generation circuit 81 can send the on-time information NTON (a numerical value) to the PWM signal generation circuit 83 for each switching cycle.

For example, the on-time information generation circuit 81 sends the on-time information NTON to the PWM signal generation circuit 83 depending on a send request of the on-time information from the PWM signal generation circuit 83.

A voltage Vr0 occurs between two terminals of the resistance 916 (r0) serially connected to the inductor 914.

The zero cross detecting circuit 82 inputs the voltage Vr0.

The zero cross detecting circuit 82 detects a time when a current flowing through the inductor 914 (an inductor current iL) became zero.

The zero cross detecting circuit 82 generates a zero cross detection signal ZCRSS when the inductor current iL became zero.

When the zero cross detection signal ZCRSS was input, the PWM signal generation circuit 83 outputs a turn on signal TRNON.

After the PWM signal generation circuit 83 output the turn on signal TRNON when a time based on the on-time information NTON passed, the PWM signal generation circuit 83 generates a turn off signal TRNOFF.

The turn on signal TRNON and the turn off signal TRNOFF are input to a driver 802.

The driver 802 drives the switch 912 based on the switch drive signal STON.

PRIOR ART DOCUMENTS

PATENT DOCUMENTS

PATENT DOCUMENT 1:

WO2010/023978

(JP 2010-023978)

DISCLOSURE OF INVENTION

PROBLEM TO BE SOLVED BY THE INVENTION:

However, in the power converter circuit 9 shown in FIG. 20, a power loss by the resistance 916 (r0) occurs.

If it can be detected the time when an inductor current iL becomes zero without using the resistance 916, the resistance 916 is not needed.

The time when the inductor current iL becomes zero may be detected by measuring a back electromotive force VL which occurred in the inductor 914.

The relation of the back electromotive force VL and the inductor current iL is represented by a formula (1).

$$VL = - (diL/dt) ... (1)$$

However, the inductor current iL is not demanded directly by the back electromotive force VL (it is understood from a formula (1)).

That is, the inductor current iL can be calculated by integrating the formula (1).

However, the integration constant is uncertain.

Thus, a change of the inductor current iL is not detected precisely.

An object of the invention is to provide a control device of a power converter circuit that can be controlled in the critical mode by acquiring a change of a current flowing through the inductor precisely.

MEANS FOR SOLVING PROBLEM:

A control device of the present invention assumes the following subject matter.

(1)

A control device of a power converter circuit repeating an accumulation of energy to an inductor and releasing the energy accumulated to the inductor at each turn on/turn off timing of a switch or switches, comprising:

> an on-time information generation circuit that inputs a power converter circuit information including at least an output voltage value of power converter circuit, and generates on-time information of the switch/switches;
> a zero cross detecting circuit which detects a time when a current flowing through the inductor became zero by inputting a voltage between both terminals of the inductor, and generates a zero cross detection signal when the current became zero;
> a PWM signal generation circuit that inputs the on-time information and the zero cross detection signal, and generates a turn on signal and a turnoff signal:

>> wherein the zero cross detecting circuit comprises an edge detecting circuit, and outputs the zero cross detecting signal when the edge detecting circuit detected the edge appeared in a voltage between both terminals of the inductor; and the PWM signal generation circuit generates the turn on signal, and generates the turnoff signal when a time based on the on-time information is passed.

The power converter circuit may be a DC/DC converter or an AC/DC converter.

The DC/DC converter may be a buck type, a boost type or a boost/buck type.

Two power converter circuits may be connected in series.

In this case, the control device of the present invention is provided to each power converter circuit, respectively.

The control device of the present invention is connected to a power converter circuit, and the control device that is not a control device of the present invention is connected to another power converter circuit.

In the case that the power converter circuit is an AC/DC converter, a DC/DC converter is connected to output terminals of the rectifying circuit.

The output signal of the rectifying circuit is typically a direct current (a pulsating current).

The DC/DC converter converts the direct current output signal (typically a pulsating current) of the rectifying circuit to a stable direct current.

The A/D converter circuit is provided to the input stage of the control device.

The A/D converter circuit converts "the predetermined signal" of the power converter circuit to a digital value from an analog value, and outputs a converted digital value as a power converter circuit information.

"The predetermined signal" of the power converter circuit includes an output voltage, an input voltage, an output current or an input current of the power converter circuit.

Even more particularly, "a predetermined signal" includes a current flowing an inductor (an inductor current), and a current flowing a switch (a switch current), too.

An inductor current can be used to detect the edge that appears in a voltage between both terminals of the inductor.

An output voltage, an input voltage, an output current or an input current of the power converter circuit can be used to determine the on-time information, and a value of a load resister can be also used to determine the on-time information.

A driver is provided to an output stage of the control device.

The driver inputs a turn on signal, and generates a drive signal to turn on the switch.

The driver also inputs a turn off signal, and generates a drive signal to turn off the switch.

(2)

A control device of a power converter circuit according to claim 1:

wherein a voltage generated between both terminals of the inductor is input to a set terminal of the flip-flop circuit through the constant voltage circuit.

(3)

A control device of a power converter circuit according to claim 1 or 2:

the zero cross detecting circuit includes a differential circuit to an input stage of the edge detecting circuit, and
the edge detecting circuit detects an edge appearing in the voltage of the inductor based on the differential calculus a voltage between both terminals of the inductor, wherein the differential circuit generates the differential voltage signal of the terminal voltage of the inductor.

(4)

A control device of a power converter circuit according to (1) to (3):

wherein the zero cross detecting circuit comprises a differential amplification circuit to an input stage.

(5)

A control device of a power converter circuit according to (1) to (4):

wherein the current flowing inductor is controlled so that the time being zero continues for predetermined time.

EFFECT OF THE INVENTION:

In the control device of the present invention, the edge detecting circuit can detect the change of the inductor current precisely.

Thus, the control device can perform a good critical mode control.

In the control device of the present invention, the differential circuit can be provided to the input stage of the edge detecting circuit.

An edge of the voltage to occur in the inductor can be thereby detected more precisely.

Even more particularly, in the control device of the present invention, the differential amplification circuit can be provided to the input stage of the differential circuit.

In this case, the gain lack of the differential circuit is compensated for by the differential amplification circuit.

BRIEF DESCRIPTION OF DRAWINGS

[FIG. 1]

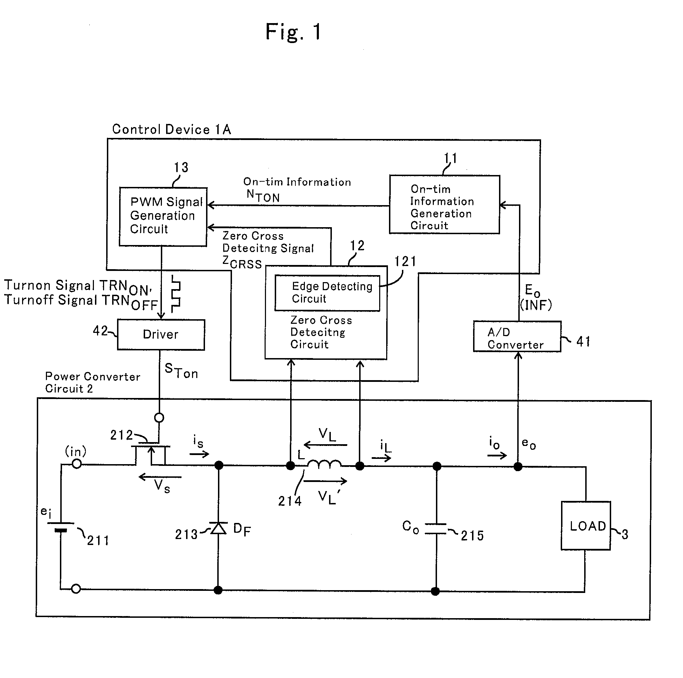

FIG. 1 is an illustration showing a first embodiment of a control device of the present invention that comprises a zero cross detecting circuit by an edge detecting circuit.
[FIG. 2]

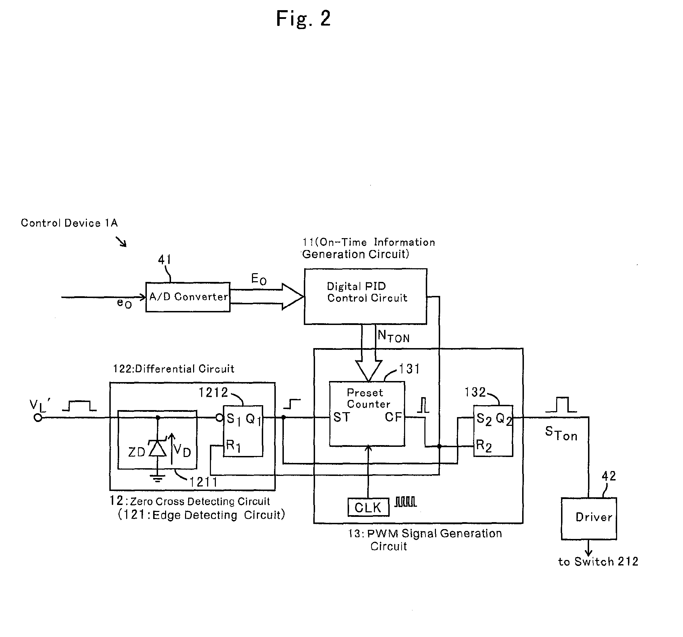

FIG. 2 is an illustration showing the control device of FIG. 1 specifically.
[FIG. 3]

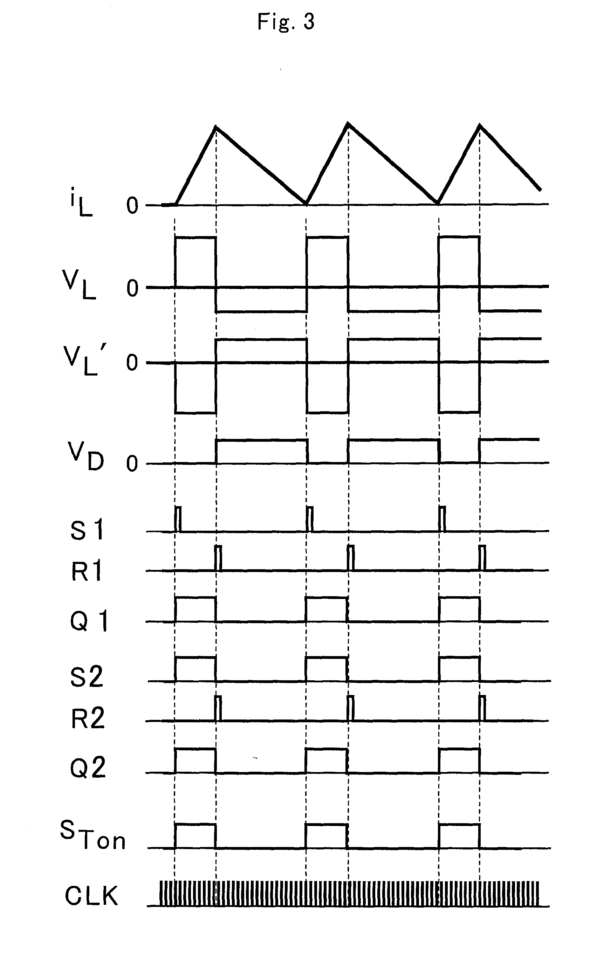

FIG. 3 is a figure that shows the control device shown in FIG. 1 and wave forms of each part of a power converter circuit.
[FIG. 4]

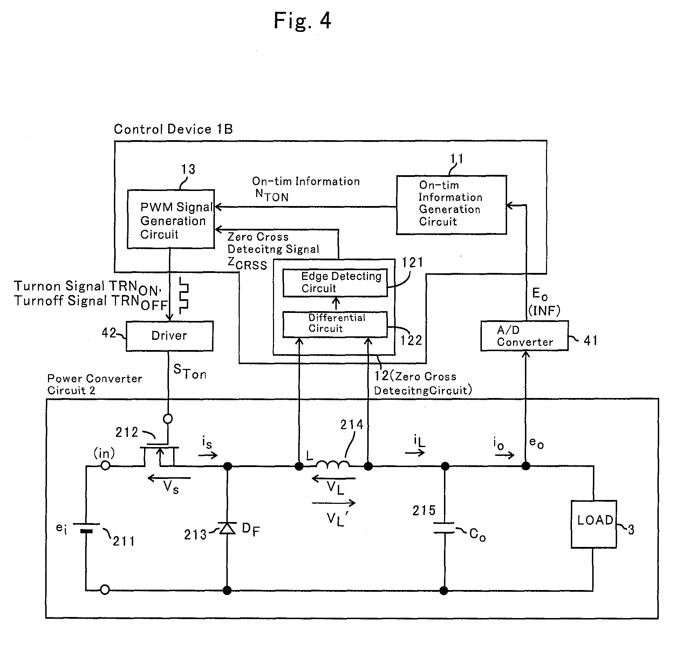

FIG. 4 is an illustration that shows a second embodiment of the control device of the present invention that a zero cross detecting circuit was constructed by an edge detecting circuit.
[FIG. 5]

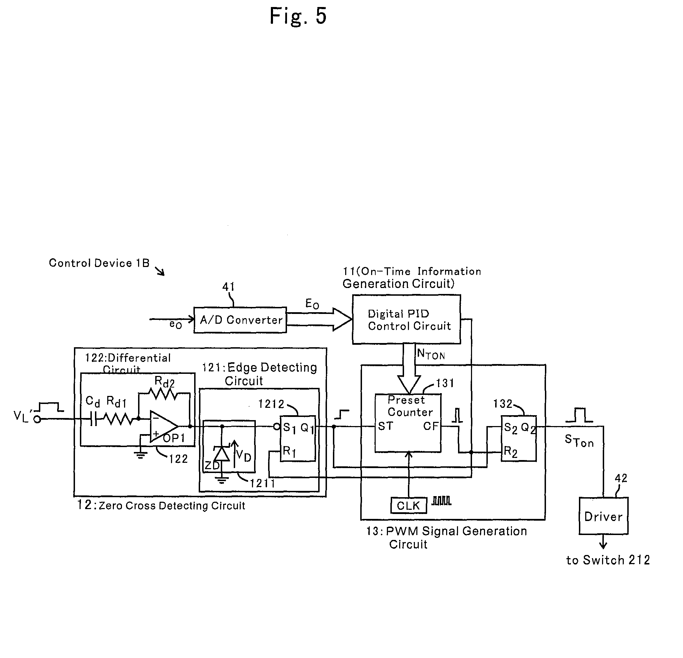

FIG. 5 is an illustration showing the control device of FIG. 4 specifically.
[FIG. 6]

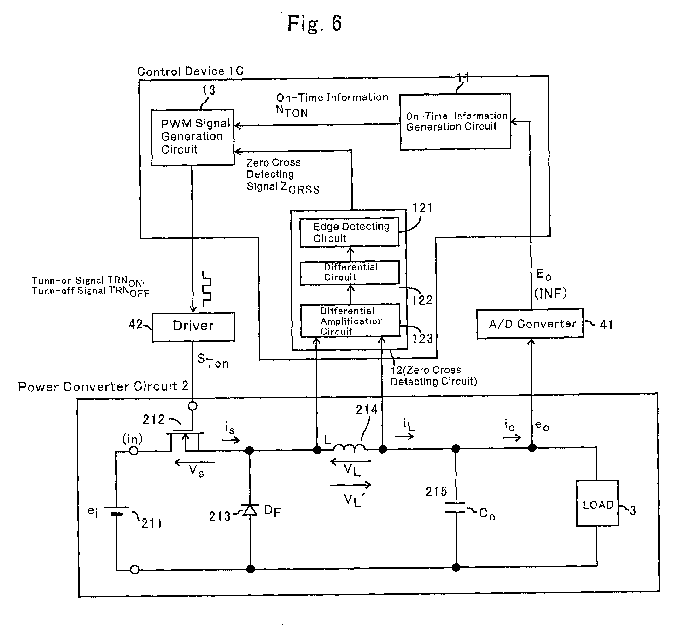

FIG. 6 is an illustration that shows a third embodiment of the control device of the present invention that a zero cross detecting circuit was constructed by an edge detecting circuit.
[FIG. 7]

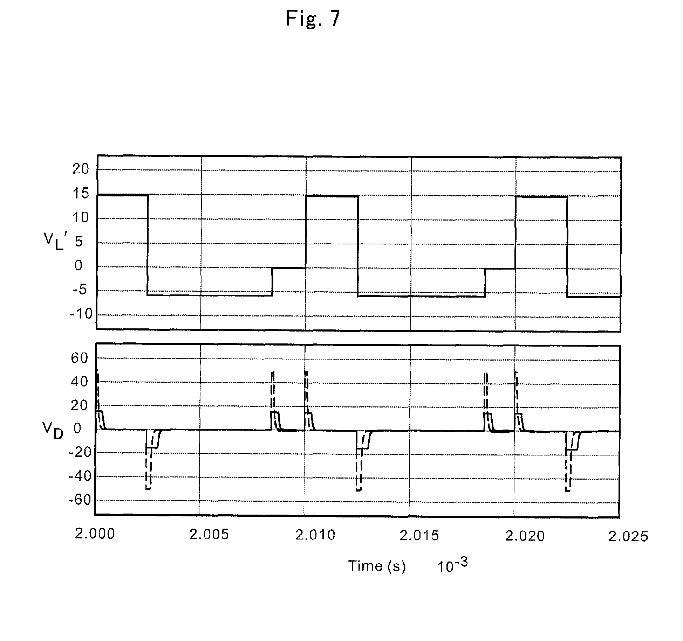

FIG. 7 is a wave form chart when the circuit fixed number (a gain) of the differential circuit is large in the second embodiment.
In FIG. 7, the top of the amplitude of output waveforms is removed.
[FIG. 8]

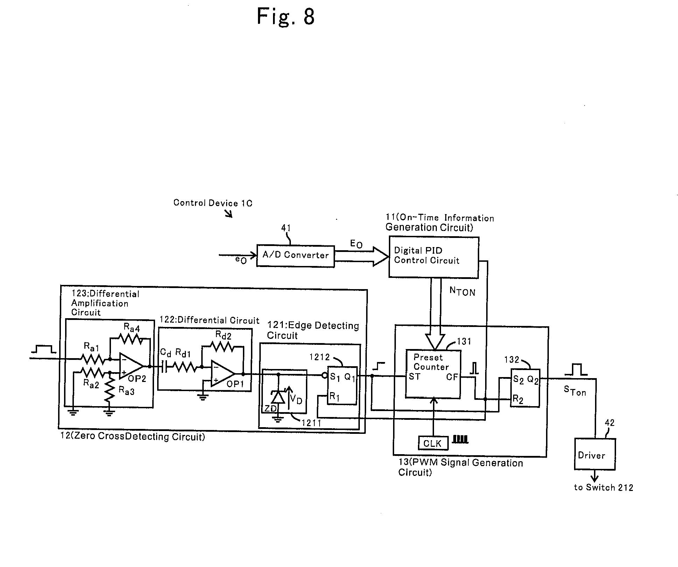

FIG. 8 is an illustration showing the control device of FIG. 6 specifically.

[FIG. 9]

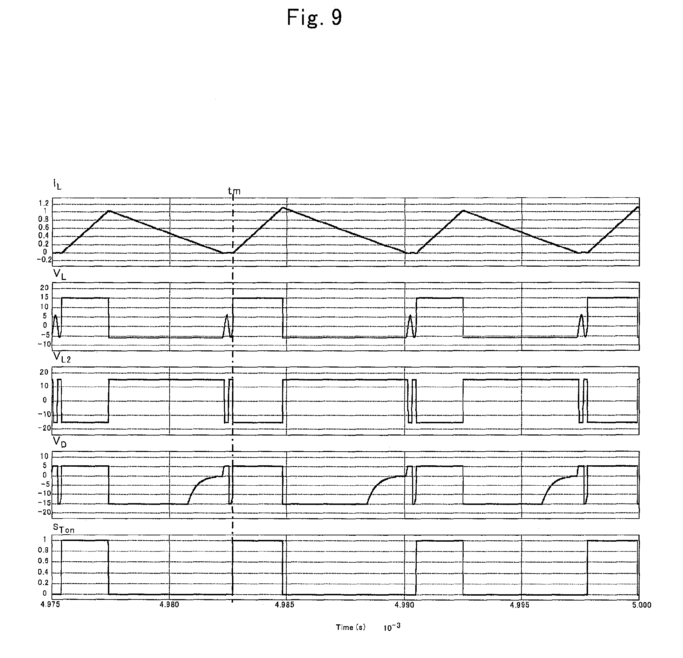

FIG. 9 is a wave form chart that shows an inductor current when a delay occurred for the zero current detection in second embodiment, the inductor voltage.
[FIG. 10]

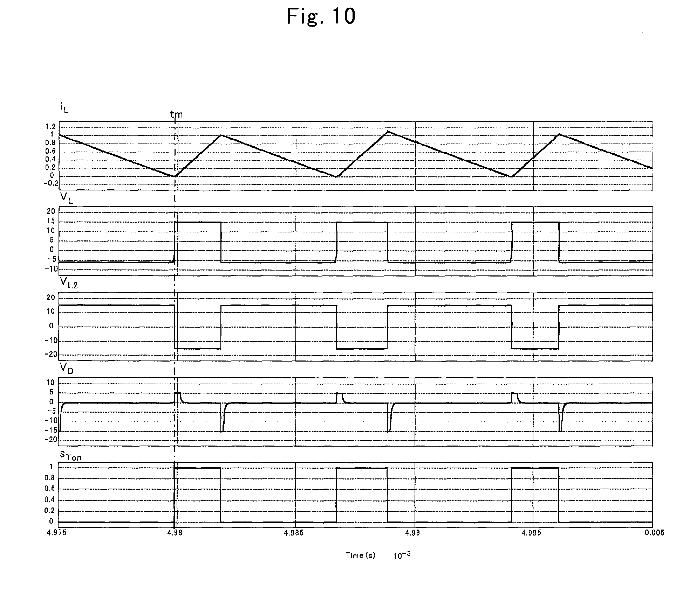

FIG. 10 is a wave form chart showing an inductor current and a switch drive signal when a delay of the zero current detection disappeared in third embodiment.
[FIG. 11]

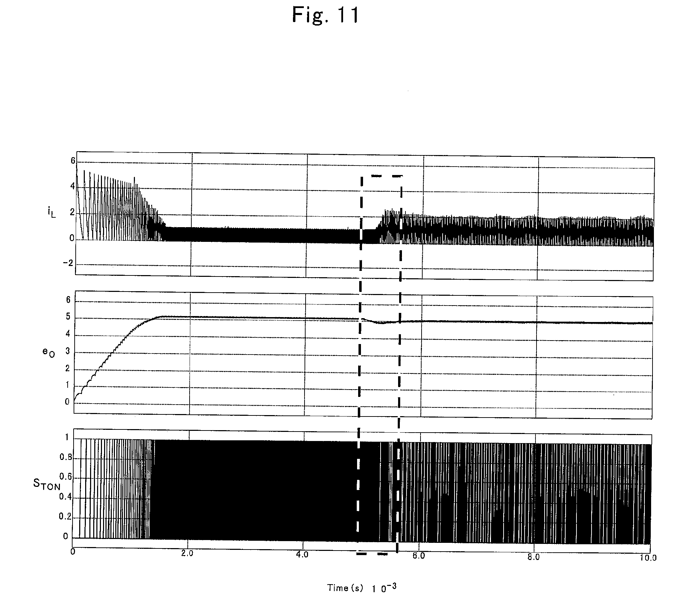

FIG. 11 is a waveform chart that shows a control result by the control device of the third embodiment.
[FIG. 12]

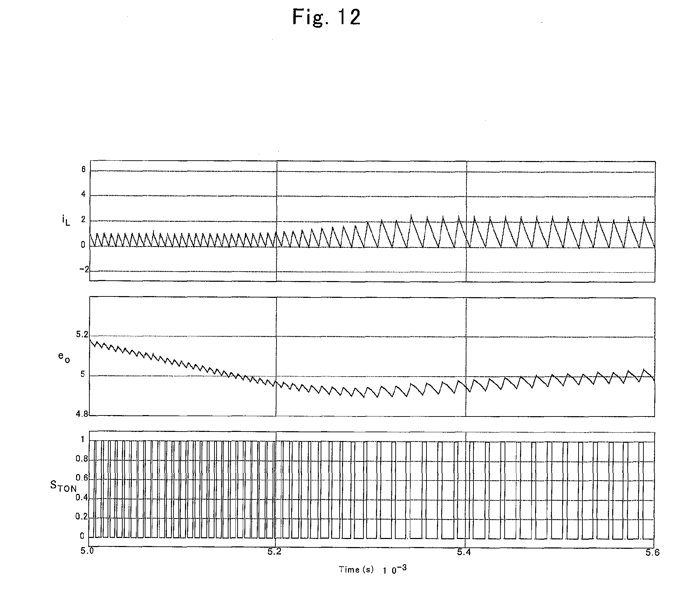

FIG. 12 is a waveform chart that shows a control result by the control device of the third embodiment.
[FIG. 13]

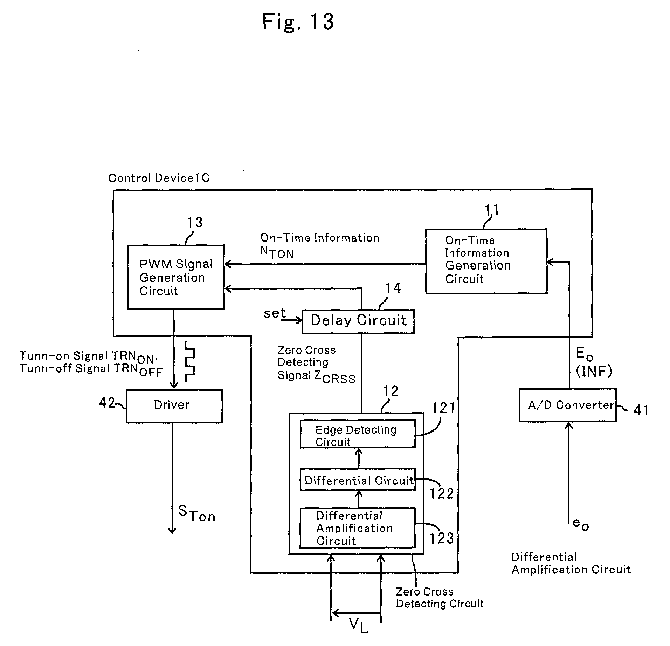

FIG. 13 is a figure that shows a control device with a delay circuit. The control device is provided to an output stage of the zero cross detecting circuit.
[FIG. 14]

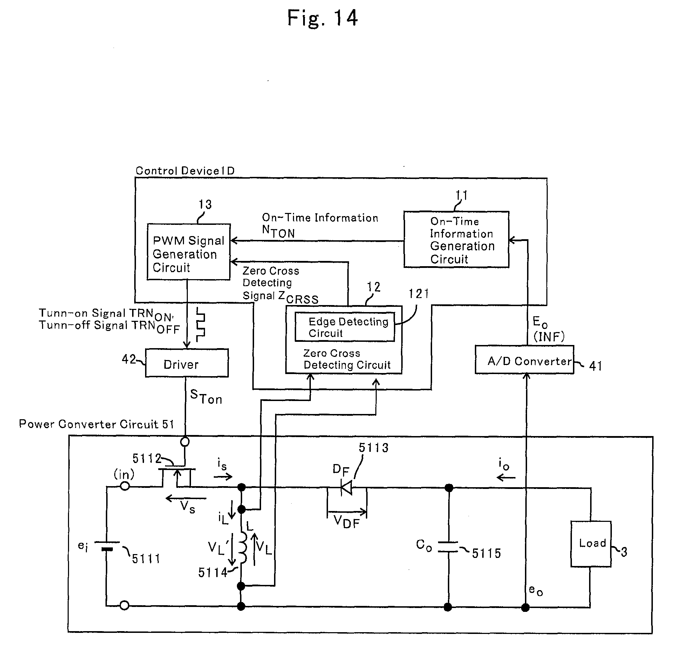

FIG. 14 is a figure that shows an embodiment that the control device of the present invention was applied to a boost/buck type (step-down type) DC/DC converter.
[FIG. 15]

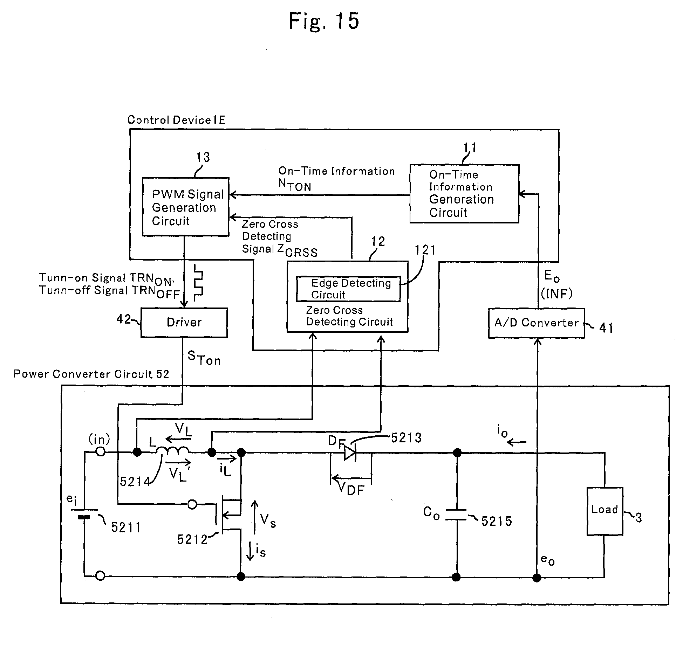

FIG. 15 is a figure that shows an embodiment that the control device of the present invention was applied to a boost type (step-up type) DC/DC converter.
[FIG. 16]

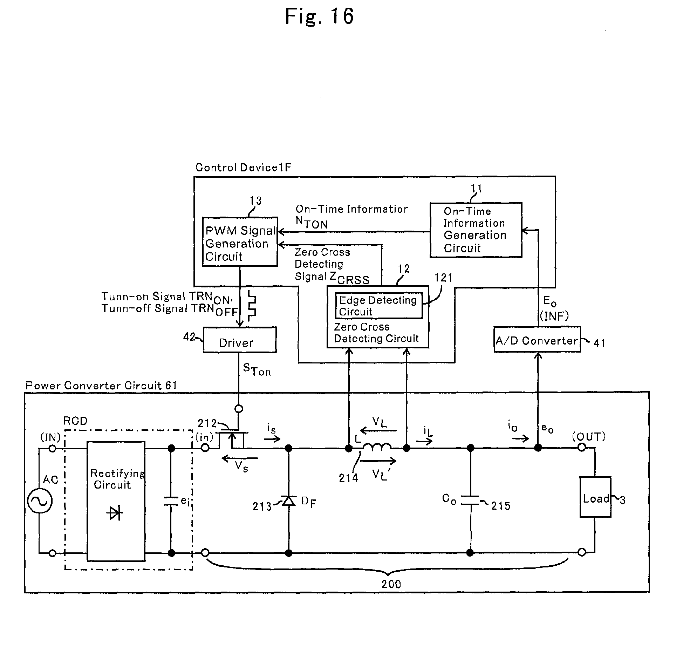

FIG. 16 is a figure that shows an embodiment that a power converter circuit is an AC/DC converter including a buck type DC/DC converter.
[FIG. 17]

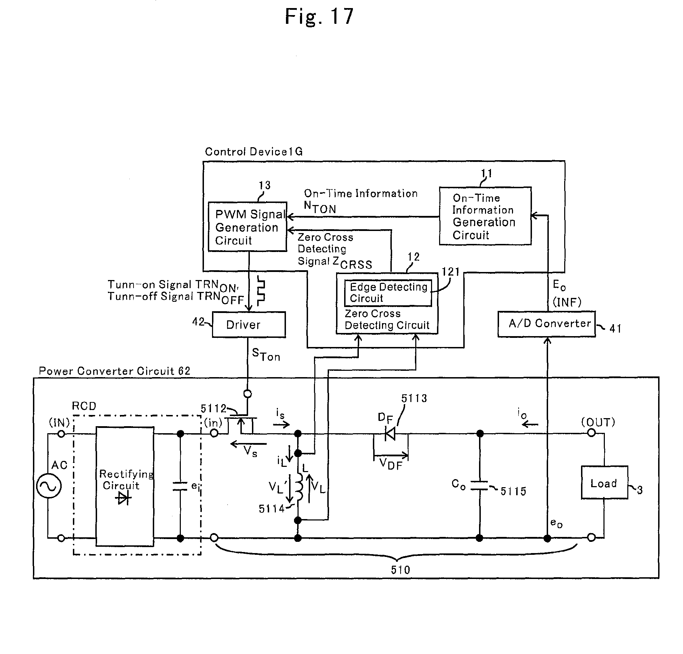

FIG. 17 is a figure that shows an embodiment that a power converter circuit is an AC/DC converter including a boost/buck type DC/DC converter.
[FIG. 18]

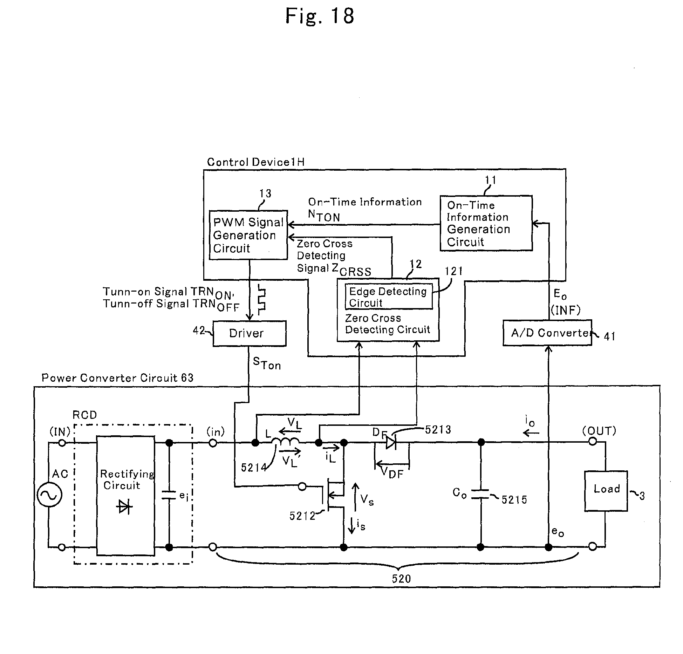

FIG. 18 is a figure that shows an embodiment that a power converter circuit is an AC/DC converter including a boost type DC/DC converter.
[FIG. 19]

FIG. 19 (A) is a figure showing a buck type (step-down type) DC/DC converter.
FIG. 19 (B) is a wave form chart showing a waveform of each part in a continuous mode.
FIG. 19 (C) is a wave form chart showing a waveform of each part in a discontinuous mode.
FIG. 19 (D) is a wave form chart showing a waveform of each part in a critical mode.
[FIG. 20]
FIG. 20 is a figure showing a conventional power conversion system to work in a critical mode.

THE BEST MODE FOR CARRYING OUT THE INVENTION

FIG. 1 is a figure showing a first embodiment of a control device of a power converter circuit of the present invention.
The power converter circuit 2 comprises a DC power supply 211, a switch 212 (a transistor), a flywheel diode 213 (DF), an inductor 214 and a capacitor 215.
A DC power supply 211 is provided to an input stage of the power converter circuit 2, and the DC power supply 211 is connected to input terminals in.
The switches 212 (a transistor) is connected to the DC power supply 211.
A cathode of the flywheel diode 213 (DF) is connected to switch 212, and an anode of that is grounded.
The inductor 214 is connected to the switch 212.
A terminal of capacitor 215 is connected to the inductor 214, and another terminal is grounded.
A load 3 is connected to both ends of capacitor 215.
In the power converter circuit 2, energy is accumulated when the switch 212 is turned on, and the accumulated energy is released to the load 3 when the switch 212 is turned off.
The control device 1A includes an on-time information generation circuit 11, a zero cross detecting circuit 12 and a PWM signal generation circuit 13.
The on-time information generation circuit 11 inputs a power converter circuit information INF including output a voltage value EO of at least the power converter circuit 2 (a digital value according to an analog output voltage eO of the power converter circuit 2), and the on-time information NTON of the switch 212 is generated.
In the present embodiment, the power converter circuit information INF is an output voltage value EO of the power converter circuit 2.
The present invention is not limited to the control device 1A of the embodiment of FIG. 1.
For example, a digital value EO of the output voltage eO and at least one of a digital value IL of an inductor current iL, a digital value EI of an input voltage ei or a digital value IO of an output current iO are input to the control device through the A/D converters, and the control device can generate the on-time information NTON based on these input values.
The output voltage eO of the power converter circuit 2 is converted to a digital signal (a digital value EO of the output voltage eO) by the A/D converter 41, and the digital value EO is input to the on-time information generation circuit 11.
The on-time information generation circuit 11 is a PID control circuit and a digital filter (IIR, FIR).
The on-time information (a numerical value, in the present embodiment) can be sent out to the PWM signal generation circuit 13 at each switching cycle.
For example, the on-time information generation circuit 11 sends the on-time information to the PWM signal generation circuit 13 depending on a send request of the on-time information from the PWM signal generation circuit 13.

In this case, the on-time information generation circuit 11 can start to generate the on-time information in the next switching cycle when the on-time information was sent.

The zero cross detecting circuit 12 inputs a terminal voltage (an inductor voltage VL') of an inductor 214, and detects the timing when the current flowing through the inductor 214 (inductor current iL) becomes zero.

Even more particularly, the zero cross detecting circuit 12 generates a zero cross detection signal ZCRSS when an inductor current iL became zero.

The zero cross detecting circuit 12 has an edge detecting circuit 121.

When the inductor current iL becomes zero, the edge detecting circuit 121 detects an edge of a voltage emerging to the inductor 214, and generates a zero cross detection signal.

Note that, in FIG. 1, a terminal voltage (an inductor voltage VL') is a back electromotive force of the inductor 214 based on the terminal voltage of the input stage.

The absolute value of VL' is the same as the absolute value of the electromotive force VL of the inductor 214 on the basis of the terminal voltage of the output ($|VL|=|VL'|$).

A plus or minus sign of VL and VL'(VL = -VL') are reverse.

The PWM signal generation circuit 13 inputs the on-time information and a zero cross detection signal, and generates a turn on signal and a turn off signal.

Specifically, the PWM signal generation circuit 13 generates a turn on signal TRNON when the zero cross detection signal ZCRSS was input.

In addition, the PWM signal generation circuit 13 generates a turn off signal TRNOFF after a time based on the on-time information NTON passed.

The turn on signal TRNON and the turn off signal TRNOFF are input to the driver 42, and the driver 42 drives the switch 212 based on the switch drive signal.

FIG. 2 is a circuit showing the control device 1A of FIG. 1 specifically.

The A/D converter 41 converts an analog output voltage eO into a digital value (a digital output voltage value EO).

In FIG. 2, the on-time information generation circuit 11 is a digital PID control circuit.

The on-time information generation circuit 11 inputs a digital output voltage value EO as a power converter circuit information INF, and generates on-time information NTON.

The on-time information NTON is preset to the preset counter 131 (it is described below) of the PWM signal generation circuit 13.

The zero cross detecting circuit 12 comprises the constant voltage circuit 1211 and the flip-flop circuit 1212.

The constant voltage circuit 1211 and the flip-flop circuit 1212 comprises the edge detecting circuit 121.

The edge emerging in a terminal voltage (inductor voltage VL') of the inductor 214 is input to the set terminal S1 of the flip-flop circuit 1212 through the constant voltage circuit 1211.

When a falling edge is input to the set terminal S1, the flip-flop circuit 1212 outputs a high level signal (an H level signal) from the output terminal Q1.

The PWM signal generation circuit 13 comprises a preset counter 131 and a flip-flop circuit 132.

As described earlier, the on-time information NTON (a digital value) is preset to the preset counter 131. The output terminal Q1 of the flip-flop circuit 1212 is connected to the input terminal ST of the preset counter 131.

When the high level signal (a rising edge of the high level signal) is input to the input terminal ST, the preset counter 131 starts counting.

In addition, the preset counter 131 outputs a count end signal (a pulse) from an output terminal CF when the preset value (the on-time information NTON) reached a pre-set value.

The output terminal of the preset counter 131 is connected to a reset terminal R1 of the flip-flop circuit 1212 of the zero cross detecting circuit 12.

The flip-flop circuit 1212 is reset by the rising edge of the count end signal (a pulse) from the output terminal CF.

On the other hand, when a high level signal (the rising edge of the high level signal) from the output terminal Q1 of the flip-flop circuit 1212 is input to the set terminal S2 of a flip-flop circuit 132, the flip-flop circuit 132 outputs a high level signal (a H level signal) from an output terminal Q2.

In addition, the output terminal CF of the preset counter 131 is connected to the reset terminal R2 of the flip-flop circuit 132.

The flip-flop circuit 132 is reset by the rising edge of the count end signal (a pulse) from the output terminal CF of the preset counter 131.

Control device 1A is constructed as above.

Thus, the switch drive signal STON with the time width based on on-time information NTON is output to the driver 42 from the flip-flop circuit 132.

The switch drive signal STON is a signal which rises up when the electromotive force VL' of the inductor 214 falls down (when the inductor current iL becomes zero).

An operation of the control device 1A of FIG. 2 is explained briefly.

The constant voltage circuit 1211 inputs an inductor voltage VL'.

(2)

The output of the constant voltage circuit 1211 is input to a set terminal (S1) of the flip-flop circuit 1212

(3)

The flip-flop circuit 1212 detects a falling edge of the inductor voltage VL', and the flip-flop circuit 1212 outputs a high level signal (an H level signal) from the output terminal Q1.

(4)

The high level signal (an H level signal) from the output terminal Q1 is input to the preset counter 131 and the set terminal S2 of the flip-flop circuit 132.

(5)

When the preset counter 131 inputs the high level signal (a H level signal) from the output terminal Q1, the on-time information NTON is preset to the preset counter 131, and the preset counter 131 starts to count the clock pulses.
At the same time, flip-flop circuit 132 outputs a rising edge signal to driver 42, and the driver 42 turns on the switch 212.

(6)

When the preset counter 131 finishes the calculation, the rising edge of the count end signal (a pulse) from the output terminal CF is input to the reset terminal R2 of the flip-flop circuit 132.
Then the flip-flop circuit 132 outputs the falling edge signal to the driver 42, and the driver 42 turns off the switch 212.
FIG. 3 is a waveform chart of each part of the control device 1A and the power converter circuit 2 shown in FIG. 1.
Reference letters in FIG. 3 are defined as follows.

iL: an inductor current,
VL: an inductor voltage
VL': an inversion voltage of the inductor voltage
VD: a output voltage of the constant voltage circuit 1211
S1: a voltage that is input to the set terminal S1 of the flip-flop circuit 1212
R1: a voltage that is input to the reset terminal R1 of the flip-flop circuit 1212
Q1: a voltage of the output terminal Q1 of the flip-flop circuit 1212
S2: a voltage that is input to the set terminal S2 of the flip-flop circuit 132
R2: a voltage that is input to the reset terminal R2 of the flip-flop circuit 132
Q2: a voltage of the output terminal Q2 of the flip-flop circuit 132
STON: an input of the driver 42 (a voltage of the output terminal Q2 of the flip-flop circuit 132)
CLK: a clock for driving the preset counter 131
A clock for counts of preset counter 131

FIG. 4 is a circuit diagram that shows a second embodiment of the control device of the present invention.
In this embodiment, a control device is shown by a reference letter 1B.
The power converter circuit 2 is the same as the power converter circuit of FIG. 1.
In the zero cross detecting circuit 12 of the control device 1B, a differential circuit 122 is provided to the input stage of the detecting circuit 121.
The differential circuit 122 inputs a terminal voltage of inductor 214 (an inductor voltage VL') and generates a differential voltage signal VDIF.
The edge detecting circuit 121 can detect surely an edge of the terminal voltage (inductor voltage VL') of the inductor 214 based on a differential calculus signal (a differential calculus voltage signal VDIF) of the inductor current iL which the differential circuit 122 generates.
FIG. 5 is a circuit diagram showing the control device 1B of FIG. 4 specifically.
In FIG. 5, the zero cross detecting circuit 12 comprises an edge detecting circuit 121 and a differential circuit 122.
The edge detecting circuit 121 comprises a constant voltage circuit 1211 and a flip-flop circuit 1212 like FIG. 2.
The edge of the voltage (inductor voltage VL') to occur to the inductor 214 (refer to FIG. 4) is converted to a signal that a falling edge (or a rising edge) is steep by the differential circuit 122.
The converted signal is input to the set terminal S1 of the flip-flop circuit 1212 via a constant voltage circuit 1211.
The converted signal is input via the constant voltage circuit 1211.
The set terminal S1 of the flip-flop circuit 1212 inputs a falling edge (an output of the differential circuit 122).
The flip-flop circuit 1212 can output a high level signal (an H level signal) from the output terminal Q1. The differential circuit 122 of FIG. 5 is a typical differential circuit using an operational amplifier OP1. In the differential circuit 122, a series circuit of an input capacitor Cd and an input resistance Rd1 is connected to an input terminal of the operational amplifier OP1.
The feedback resister Rd2 is connected between an input terminal and an output terminal of the operational amplifier OP1.
An operation of the control device 1B of FIG. 5 is explained briefly.

(1)

An edge of inductor voltage VL' suddenly changes by an effect of the differential circuit 122.

The constant voltage circuit 1211 inputs an edge of inductor voltage VL' which suddenly changed.

(2)

An output of the constant voltage circuit 1211 is input into the set terminal (S1) of the flip-flop circuit 1212.

(3)

When a falling edge of the inductor voltage VL' was detected, the flip-flop circuit 1212 outputs a high level signal (an H level signal) (a rising edge of the high level signal) from the output terminal Q1.

(4)

The high level signal (the H level signal) from the output terminal Q1 is input into the preset counter 131 and the set terminal S2 of the flip-flop circuit 132.

(5)

When the preset counter 131 input the high level signal from the output terminal Q1, the preset counter 131 inputs the on-time information NTON and starts counting.

The flip-flop circuit 132 outputs a rising edge (a rising edge of a switch drive signal STON) to the driver 42 at the same time.

The driver 42 turns on the switch 212 when the driver 42 inputs the rising edge of the switch drive signal STON.

(6)

When the preset counter 131 finished counting, the preset counter 131 outputs the rising edge signal of a count end signal (a pulse) from the output terminal CF.

The rising edge is input to the reset terminal R2 of the flip-flop circuit 132.

When the rising edge input to the reset terminal R2, the flip-flop circuit 132 outputs a falling edge signal (a falling edge of the switch drive signal STON) to the driver 42.

The driver 42 turns off the switch 212, when the falling edge signal of the switch drive signal STON was input.

FIG. 6 is a circuit diagram that shows a third embodiment of the control device of the present invention. In this embodiment, a control device is shown by a reference letter 1C.

The power converter circuit 2 is the same as the power converter circuit of FIG. 1.

As mentioned earlier, in the control device 1B of the second embodiment, the edge of the inductor voltage VL' is suddenly changed by the differential circuit 122, and the change is detected.

The changes of the inductor current iL can be usually acquired precisely.

However, the high of the differential output waveform is cut off as shown in FIG. 7 when the circuit constant (a gain) of the differential circuit 122 is large (refer to a broken line of FIG. 7).

As a result, a delay occurs for the current detection (it is described below about "the zero current detection").

In this embodiment, by the differential amplification circuit 123 described below, a gain lack of the differential circuit 122 is compensated for.

The zero cross detecting circuit 12 of the control device 1C comprises an edge detecting circuit 121, the differential circuit 122 and a differential amplification circuit 123.

The structure of the edge detecting circuit 121 and the differential circuit 122 are similar to the structure explained in the second embodiment.

The differential amplification circuit 123 is connected to an input terminal of the differential circuit 122. The differential amplification circuit 123 amplifies a terminal voltage (an inductor voltage VL') of the inductor 214.

The differential circuit 122 generates a differential voltage signal VDIF from an output of the differential amplification circuit 123.

The edge detecting circuit 121 can more surely detect an edge of a terminal voltage (an inductor voltage VL') of the inductor 214 based on a differential calculus signal (a differential voltage signal VDIF that a gain lack was compensated) of an inductor current iL which the differential circuit 122 generates.

FIG. 8 is a circuit diagram showing the control device 1C of FIG. 6 specifically.

In FIG. 8, the zero cross detecting circuit 12 comprises an edge detecting circuit 121, a differential circuit 122 and the differential amplification circuit 123.

The edge detecting circuit 121 comprises a constant voltage circuit 1211 and a flip-flop circuit 1212 like FIG. 2.

The differential circuit 122 comprises an operational amplifier OP1, an input capacitor Cd, an input resistance Rd1 and a feedback resister Rd2 same as the second embodiment.

The edge of the voltage (inductor voltage VL') to occur to the inductor 214 (refer to FIG. 4) is converted to a signal that a falling edge (or a rising edge) is steep by the differential circuit 122.

The converted signal is input to the set terminal S1 of the flip-flop circuit 1212 via a constant voltage circuit 1211.

The converted signal is input via the constant voltage circuit 1211.

The set terminal S1 of the flip-flop circuit 1212 inputs a falling edge (an output of the differential circuit 122).

The flip-flop circuit 1212 can output a high level signal (an H level signal) from the output terminal Q1. The differential circuit 123 of FIG. 5 is a typical differential circuit using an operational amplifier OP2. An input resistance Ra1 is connected to an input terminal of the operational amplifier OP2.

The grounding resistance (it comprises a parallel circuit of a resistance Ra2 and a resistance Ra3) is connected to a grounding terminal of the operational amplifier, and a feedback resister Ra4 is connected between an input terminal and an output terminal of the operational amplifier OP2.

Note that, the resistance value of Ra1 and the resistance value of Ra2 are set equally, and the resistance value of Ra3 and the resistance value of Ra4 are set equally.

An operation of the control device 1C of FIG. 8 is explained briefly.

(1)

An inductor voltage VL' is amplified by the differential amplification circuit 123.

An edge of amplified inductor voltage VL' suddenly changes by an effect of the differential circuit 122. The constant voltage circuit 1211 inputs an edge of inductor voltage VL' which suddenly changed.

(2)

An output of the constant voltage circuit 1211 is input into the set terminal (S1) of the flip-flop circuit 1212.

(3)

When a falling edge of the inductor voltage VL' was detected, the flip-flop circuit 1212 outputs a high level signal (an H level signal) (a rising edge of the high level signal) from the output terminal Q1.

(4)

The high level signal (the H level signal) from the output terminal Q1 is input into the preset counter 131 and the set terminal S2 of the flip-flop circuit 132.

(5)

When the preset counter 131 input the high level signal from the output terminal Q1, the preset counter 131 inputs the on-time information NTON and starts counting.

The flip-flop circuit 132 outputs a rising edge (a rising edge of a switch drive signal STON) to the driver 42 at the same time.

The driver 42 turns on the switch 212, when the driver 42 inputs the rising edge of the switch drive signal STON.

(6)

The preset counter 131 outputs the rising edge signal of a count end signal (a pulse) from the output terminal CF when the preset counter 131 finished counting.

The rising edge is input to the reset terminal R2 of the flip-flop circuit 132.

The flip-flop circuit 132 outputs a falling edge signal (a falling edge of the switch drive signal STON) to the driver 42 when the rising edge input to the reset terminal R2.

In the control device 1B of the previously described in the second embodiment, a gain lack by the differential circuit 122 occurs, and the zero current detection may be late.

FIG. 9 shows an inductor current iL, an inductor voltage VL, an inductor voltage VL2 for which a gain lack was compensated, a terminal voltage VD of the diode ZD and a switch drive signal STON.

Due to a delay of the zero current detection, the control in the critical mode may become impossible (refer to a time tm of FIG. 9 and "discontinuous mode" of FIG. 19 (C)).

In the third embodiment, the delay of the zero electric current detection due to the gain lack can be canceled, and a critical mode can be implemented by a differential amplification circuit 123,

FIG. 10 is a waveform chart when a delay of the zero current detection was broken off

FIG. 10 shows an inductor current iL, an inductor voltage VL, an inductor voltage VL2 compensated a gain lack, a terminal voltage VD of the diode ZD and a switch drive signal STON.

A result of the control by a control device 1C of the third embodiment is shown below.

FIG. 11 and FIG. 12 show a response of the power converter circuit 2 when the load 3 suddenly changed.

In FIG. 11 and FIG. 12, the input voltage is 20[V], the output voltage eO is 5[V] and the resistance value of the load 3 varies from 10[ohm] to 5[ohm].

FIG. 11 shows the inductor current iL, the output voltage eO, and the switch drive signal STON.

FIG. 12 is an enlarged view of a part of FIG. 11 (an area surrounded in bold line).

As is apparent from FIGS. even if the load changes greatly, the output voltage eO does not change substantially, and the output voltage is returned to the immediately steady value.

"Critical mode" shown in FIG. 10 is a complete "critical mode". there are few periods when a slant of the current iL becomes zero. Thus, in the complete "critical mode", a good control is carried out.

However, the control with the mode (a mode existing at the time when a current slant is a short period of zero) which is near to "a discontinuous mode" shown in FIG. 9 may be preferred in some cases. Such a mode is "critical mode" of the present invention substantially, too.

In this case, by the either control device of the first embodiment third embodiment, a current incline can generate a period of zero positively.

That is, in the present invention, the control device can control an inductor current so that the time when the inductor current iL becomes zero continues at micro time.

Specifically, an amplification factor of the amplifier and circuit constants of the differential circuit can be changed.

An output timing of the zero cross detection signal ZCRSS is thereby adjusted.

Also, as shown in FIG. 13, the turn on timing of the switch 212 (it should refer to the control device 1C of FIG. 6) can be delayed by the delay circuit 14 provided in the output stage of the zero cross detecting circuit 12 positively.

For example, the delay circuit 14 may comprise a preset counter and a flip-flop same as a case to generate the turnoff signal of the PWM signal.

FIG. 14 shows other embodiment of the control device of the power converter circuit of the present invention.

In FIG. 14, a control device 1D is applied to the boost/buck type DC/DC converter (power converter circuit 51).

FIG. 15 shows other embodiment of the control device of the power converter circuit of the present invention.

In FIG. 15, a control device 1E is applied to the boost type DC/DC converter (a power converter circuit 51).

An effect of the control device 1D of FIG. 14 or the control device IE of FIG. 15 is the same as an effect of the control device in the embodiment (the first, the second or the third embodiment).

In the control device 1D of FIG. 14 and the control device 1E of FIG. 15, the edge detecting circuit 121 of the zero cross detecting circuit 12 can detect a change of inductor current iL precisely.

Thus, the control device can carry out a good critical control.

In the control device 1D of FIG. 14 and the control device 1E of FIG. 15, the differential circuit can be provided to the input stage of the edge detecting circuit 121, and the differential amplification circuit can be provided to the input stage of this differential circuit more.

FIG. 16 shows other embodiment of the control device of the power converter circuit of the present invention.

In FIG. 15, a control device 1F is applied to an AC/DC converter (a power converter circuit 61).

The power converter circuit 61 of FIG. 16 comprises a rectifying circuit RCD inputting an electric power and a DC/DC converter circuit 200 inputting the rectification output of the rectifying circuit RCD.

In this embodiment, the rectifying circuit RCD comprises a full wave rectifier and an output capacitor.

The rectifying circuit RCD performs full-wave rectification of a single-phase alternating current input.

The rectifying circuit RCD converts a rectified current to a pulsating current.

The DC/DC converter circuit 200 is the same as the structure that removed the DC power supply 211 from the power converter circuit 2 (a buck type DC/DC converter) of FIG. 1.

The structure of the control device 1F is the same as the control device 1A of FIG. 1.

The input of the DC/DC converter circuit 200 is a pulsating current, however the control device 1F detects a change of inductor current iL precisely, and a good critical mode control can be performed.

It is not illustrated, but in the power converter circuit 61 of FIG. 16, a control device same as the control device 1B shown in FIG. 4 can be used in substitution for the control device 1F.

The control device 1B comprises a differential circuit 122 to the input stage of the edge detecting circuit 121.

It is not illustrated, but in the power converter circuit 61 of FIG. 16, a control device same as the control device 1C shown in FIG. 6 can be used in substitution for the control device 1F.

The control device 1C comprises a differential circuit 122 and a differential amplification circuit 123 to the input stage of the edge detecting circuit 121.

FIG. 17 is a figure to explain the other embodiment to apply the control device of the present invention to an AC/DC converter.

In FIG. 17, the AC/DC converter (power converter circuit 62) is controlled by a control device 1G.

The power converter circuit 62 of FIG. 17 comprises a rectifying circuit RCD and a DC/DC converter circuit 510.

The rectifying circuit RCD inputs an electric power, and the DC/DC converter circuit 510 inputs the rectification output of the rectifying circuit RCD.

The rectifying circuit RCD in FIG. 18 is the same as the rectifying circuit RCD described in FIG. 16. The DC/DC converter circuit 510 is the same as a circuit which removed the DC power supply 5111 from the power converter circuit 51 (the boost/buck type DC/DC converter) of FIG. 14.

The control device 1G is the same as a control device 1A of FIG. 1, and the control device 1G detects a change of the inductor current iL precisely, and a good critical mode control can be executed.

In the power converter circuit 62 of FIG. 17, a control device like the control device 1B (it comprises the differential circuit 122 to the input stage of edge detecting circuit 121) shown in FIG. 4 can be used replacing with the control device 1G.

In the power converter circuit 62 of FIG. 17, a control device like the control device 1C (it comprises the differential circuit 122 and the differential amplification circuit 123 to the input stage of the edge detecting circuit 121) shown in FIG. 6 can be used replacing with the control device 1G.

FIG. 18 is a figure to explain the other embodiment to apply the control device of the present invention to an AC/DC converter.

In FIG. 18, the AC/DC converter (the power converter circuit 63) is controlled by the control device 1H. The power converter circuit 63 of FIG. 18 comprises a rectifying circuit RCD and a DC/DC converter circuit 520.

The rectifying circuit RCD inputs an electric power, and the DC/DC converter circuit 520 inputs the rectification output of the rectifying circuit RCD.

A rectifying circuit RCD in FIG.18 is the same as the rectifying circuit RCD described in FIG. 16.

The DC/DC converter circuit 520 is the same as a circuit which removed the DC power supply 5211 from the power converter circuit 52 (the boost type DC/DC converter) of FIG. 15.

The control device 1H is the same as a control device 1A of FIG. 1, and the control device 1H detects a change of the inductor current iL precisely, and a good critical mode control can be executed.

In the power converter circuit 63 of FIG. 18, a control device like the control device 1B (it comprises the differential circuit 122 to the input stage of the edge detecting circuit 121) shown in FIG. 4 can be used replacing with the control device 1H.

In the power converter circuit 63 of FIG. 18, a control device like the control device 1C (it comprises the differential circuit 122 and the differential amplification circuit 123 to the input stage of the edge detecting circuit 121) shown in FIG. 6 can be used replacing with the control device 1H.

Note that output terminal OUT of the power converter circuit 61, 62 or 63 (AC/DC converters) can be connected to an input terminal (in) of the buck type DC/DC converter (the power converter circuit 2) of FIG. 1, an input terminal (in) of the boost/buck type DC/DC converter (the power converter circuit 51) of FIG. 14 or an input terminal (in) of the boost type DC/DC converter (the power converter circuit 52) of FIG. 15 (these embodiments are not illustrated).

In the same way, the output terminal OUT of the power converter circuit 51 or 52 (DC/DC converter) can be connected to an input terminal (in) of the buck type DC/DC converter (power converter circuit 2) of FIG. 1, an input terminal (in) of the boost/buck type DC/DC converter (the power converter circuit 51) of FIG. 14 or an input terminal (in) of the boost type DC/DC converter (power converter circuit 52) of FIG. 15 (these embodiments are not illustrated).

EXPLANATIONS OF THE LETTERS OF NUMERALS:

1A, 1B, 1C, 1D, IE, 1F, 1G, 1H, 8: control device
2, 6, 9, 51, 52, 61, 62, 63: power converter circuit
3,900: load
11,81 : on-time information generation circuit
12, 82 : zero cross detecting circuit
13, 83: PWM signal generation circuit
14: delay circuit
21,214,914: inductor
31, 41, 801: A/D converter
32, 42,802: driver
121: edge detecting circuit
122: differential circuit
123: differential amplification circuit
131: preset counter
132, 1212: flip-flop circuit
200: DC/DC converter circuit
211,911, 5111, 5211: DC power supply
212,912: switch
213,913: flywheel diode
215,915: capacitor
510,520: DC/DC converter circuit
916: resistance for inductor current detection
1211: constant voltage circuit
CF: output terminal of the preset counter
OP1, OP2: operational amplifier
Q1, Q2: output terminal of the flip-flop circuit
R1, R2: reset terminal of the flip-flop circuit
RCD: rectifying circuit
Ra1, Rd1: input resistance of the differential amplification circuit
Ra4, Rd2: feedback resistor of the differential amplification circuit
ZD: diode

**Claims**

1.  A control device of a power converter circuit repeating an accumulation of energy to an inductor and releasing the energy accumulated to the inductor at each turn on/turn off timing of a switch or switches, comprising:

    an on-time information generation circuit that inputs a power converter circuit information including at least an output voltage value of power converter circuit, and generates on-time information of the switch/switches ;
    a zero cross detecting circuit which detects a time when a current flowing through the inductor became zero by inputting a voltage between both terminals of the inductor, and generates a zero cross detection signal when the current became zero;

a PWM signal generation circuit that inputs the on-time information and the zero cross detection signal, and generates a turn on signal and a turnoff signal:

wherein the zero cross detecting circuit comprises an edge detecting circuit, and outputs the zero cross detecting signal when the edge detecting circuit detected the edge appeared in a voltage between both terminals of the inductor; and the PWM signal generation circuit generates the turn on signal, and generates the turnoff signal when a time based on the on-time information is passed.

2. A control device of a power converter circuit according to claim 1:

   wherein a voltage between both terminals of the inductor is input to a set terminal of the flip-flop circuit through the constant voltage circuit.

3. A control device of a power converter circuit according to claim 1 or 2:

   the zero cross detecting circuit includes a differential circuit to an input stage of the edge detecting circuit, and the edge detecting circuit detects an edge appearing in the voltage of the inductor based on the differential calculus a voltage between both terminals of the inductor, wherein the differential circuit generates the differential voltage signal of the terminal voltage of the inductor.

4. A control device of a power converter circuit according to claim 1 to 3:

   wherein the zero cross detecting circuit comprises a differential amplification circuit to an input stage.

5. A control device of a power converter circuit according to claim 1 to 4:

   wherein the current flowing inductor is controlled so that the time being zero continues for predetermined time.

# Fig. 1

Control Device 1A

PWM Signal Generation Circuit — 13

On-tim Information $N_{TON}$

On-tim Information Generation Circuit — 11

Zero Cross Detecitng Signal $Z_{CRSS}$

Edge Detecting Circuit — 121 — 12

Zero Cross Detecitng Circuit

Turnon Signal $TRN_{ON}$,
Turnoff Signal $TRN_{OFF}$

$E_o$ (INF)

42 — Driver

A/D Converter — 41

Power Converter Circuit 2

$S_{Ton}$

212

(in)

$i_s$

$V_s$

$V_L$

L

$i_L$

$i_o$ $e_o$

214

$V_L'$

$e_i$

211

213 — $D_F$

$C_o$ — 215

LOAD — 3

EP 2 858 222 A2

# Fig. 2

Control Device 1A

11(On-Time Information Generation Circuit)

41

$e_O$ → A/D Converter → $E_O$ → Digital PID Control Circuit

$N_{TON}$

122:Differential Circuit

$V_L'$

1212

$S_1 Q_1$

ZD, $V_D$

$R_1$

1211

12:Zero Cross Detecting Circuit
(121:Edge Detecting Circuit)

131

Preset Counter

ST    CF

CLK

13:PWM Signal Generation Circuit

132

$S_2 Q_2$

$R_2$

$S_{Ton}$

42

Driver

to Switch 212

14

## Fig. 3

# Fig. 4

Control Device 1B

PWM Signal Generation Circuit — 13

On-tim Information $N_{TON}$

On-tim Information Generation Circuit — 11

Zero Cross Detecitng Signal $Z_{CRSS}$

Edge Detecting Circuit — 121

Differential Circuit — 122

12 (Zero Cross Detecitng Circuit)

$E_o$ (INF)

A/D Converter — 41

Turnon Signal $TRN_{ON}$, Turnoff Signal $TRN_{OFF}$

42 — Driver

$S_{Ton}$

Power Converter Circuit 2

212

(in)

$i_s$

$V_s$

214

L

$i_L$

$i_o$   $e_o$

$V_L$

$V_L'$

215

$e_i$   211

213 — $D_F$

$C_o$

LOAD — 3

# Fig. 5

Control Device 1B

41

$e_O$ → A/D Converter → $E_O$

11(On-Time Information Generation Circuit)

Digital PID Control Circuit

$N_{TON}$

122:Differential Circuit

$R_{d2}$

$C_d$ $R_{d1}$

121:Edge Detecting Circuit

1212

$V_L'$

OP1

122

ZD $V_D$

1211

$S_1 Q_1$

$R_1$

131

Preset Counter

ST    CF

132

$S_2 Q_2$

$R_2$

$S_{Ton}$

42

Driver

to Switch 212

12:Zero Cross Detecting Circuit

CLK

13:PWM Signal Generation Circuit

17

## Fig. 6

Control Device 1C

PWM Signal Generation Circuit — 13

On-Time Information $N_{TON}$

On-Time Information Generation Circuit — 11

Zero Cross Detecting Signal $Z_{CRSS}$

Edge Detecting Circuit — 121

Differential Circuit — 122

Differential Amplification Circuit — 123

12(Zero Cross Detecting Circuit)

$E_o$ (INF)

A/D Converter — 41

Tunn-on Signal $TRN_{ON}$,
Tunn-off Signal $TRN_{OFF}$

42 — Driver

$S_{Ton}$

Power Converter Circuit 2

212

(in)

$i_s$

$V_s$

L

214

$i_L$

$V_L$

$V_L'$

$i_o$ $e_o$

215

$C_o$

LOAD — 3

$e_i$ — 211

213 — $D_F$

Fig. 7

# Fig. 8

Control Device 1C

41

eo → [A/D Converter] → $E_O$

11(On-Time Information Generation Circuit)

[Digital PID Control Circuit]

$N_{TON}$

123:Differential Amplification Circuit

$R_{a4}$

$R_{a1}$

$R_{a2}$  $R_{a3}$  OP2

122:Differential Circuit

$C_d$  $R_{d1}$  $R_{d2}$  OP1

121:Edge Detecting Circuit

1212

ZD  $V_D$

$S_1$  $Q_1$

$R_1$

1211

12(Zero CrossDetecting Circuit)

131

Preset Counter

ST  CF

CLK

13(PWM Signal Generation Circuit)

132

$S_2$  $Q_2$

$R_2$

$S_{Ton}$

42

Driver

to Switch 212

20

Fig. 9

Fig. 10

Fig. 11

Time (s) $10^{-3}$

Fig. 12

Time (s) $10^{-3}$

# Fig. 13

Control Device1C

On-Time Information $N_{TON}$

13
PWM Signal
Generation
Circuit

11
On-Time
Information
Generation
Circuit

set → 14 Delay Circuit

Tunn-on Signal $TRN_{ON}$,
Tunn-off Signal $TRN_{OFF}$

Zero Cross
Detecting
Signal $Z_{CRSS}$

$E_O$
(INF)

42 Driver

12

121
Edge Detecting
Circuit

A/D Converter 41

$S_{Ton}$

Differential Circuit 122

123
Differential
Amplification
Circuit

$e_O$

Zero Cross
Detecting Circuit

Differential
Amplification Circuit

$V_L$

25

# Fig. 14

## Fig. 15

Control Device 1E

13

PWM Signal
Generation
Circuit

On-Time Information
$N_{TON}$

11

On-Time
Information
Generation
Circuit

Zero Cross
Detecting
Signal $Z_{CRSS}$

12

121

Edge Detecting
Circuit

Zero Cross
Detecting Circuit

$E_o$
(INF)

Tunn-on Signal $TRN_{ON}$,
Tunn-off Signal $TRN_{OFF}$

42 — Driver

A/D Converter — 41

$S_{Ton}$

Power Converter Circuit 52

(in)

$L$

$V_L$

$D_F$ — 5213

$i_o$

5214
$V_L'$

$i_L$

$V_{DF}$

$e_i$

5211

5212

$V_s$

$C_o$ — 5215

Load — 3

$i_s$

$e_o$

Fig. 16

Control Device1F

PWM Signal Generation Circuit — 13

On-Time Information $N_{TON}$

On-Time Information Generation Circuit — 11

Zero Cross Detecting Signal $Z_{CRSS}$

Edge Detecting Circuit — 121

12

Zero Cross Detecting Circuit

$E_o$ (INF)

A/D Converter — 41

Tunn-on Signal $TRN_{ON}$, Tunn-off Signal $TRN_{OFF}$

Driver — 42

$S_{Ton}$

Power Converter Circuit 61

RCD

(IN)

AC

Rectifying Circuit

$e_i$

212 (in)

$i_s$

$V_s$

213 $D_F$

$V_L$

L

214 $V_L'$

$i_L$

$C_o$ — 215

$i_o$ $e_o$ (OUT)

Load — 3

200

EP 2 858 222 A2

# Fig. 17

**Control Device 1G**

PWM Signal Generation Circuit (13)

On-Time Information $N_{TON}$

On-Time Information Generation Circuit (11)

Zero Cross Detecting Signal $Z_{CRSS}$

Edge Detecting Circuit (121)

Zero Cross Detecting Circuit (12)

Tunn-on Signal $TRN_{ON}$,
Tunn-off Signal $TRN_{OFF}$

Driver (42)

$E_o$ (INF)

A/D Converter (41)

$S_{Ton}$

**Power Converter Circuit 62**

RCD

(IN)

AC

Rectifying Circuit

$e_i$

(in) (5112)

$i_s$

$V_s$

$i_L$

$V_L'$ $V_L$

L (5114)

$D_F$ (5113)

$V_{DF}$

$i_o$

$C_o$ (5115)

(OUT)

Load (3)

$e_o$

510

29

Fig. 18

Control Device 1H

13

On-Time Information $N_{TON}$

11

PWM Signal Generation Circuit

On-Time Information Generation Circuit

Zero Cross Detecting Signal $Z_{CRSS}$

12   121

Edge Detecting Circuit

Zero Cross Detecting Circuit

Tunn-on Signal $TRN_{ON}$,
Tunn-off Signal $TRN_{OFF}$

$E_o$ (INF)

42   Driver

A/D Converter   41

$S_{Ton}$

Power Converter Circuit 63

RCD

(IN)   (in)   L   $V_L$   $D_F$   5213   $i_o$   (OUT)

AC   Rectifying Circuit   $e_i$   5214   $V_L'$   $i_L$   $V_{DF}$   $C_o$   5215   Load   3

5212   $V_s$   $e_o$

$i_s$

520

## Fig. 19

# Fig. 20

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2010023978 A
- JP 2010023978 A